# EUROPÄISCHE PATENTANMELDUNG

(11) **EP 0 680 247 A1**
(43) Veröffentlichungstag der Anmeldung: **02.11.1995**
(21) Anmeldenummer: 95105420.4
(22) Anmeldetag: 11.04.1995
(51) Int. Cl.: H05K 3/00, B41F 35/00

(54) **Siebdruckverfahren zur Herstellung gedruckter Schaltungen sowie Anordnung zur Durchführung des Verfahrens**

(30) Priorität: 30.04.1994 DE 4415193
(71) Anmelder: Blaupunkt-Werke GmbH, D-31132 Hildesheim (DE)
(72) Erfinder: Heyne, Michael, D-31139 Hildesheim (DE); Wabnik, Helmut, D-38228 Salzgitter (DE)

(57) **Zusammenfassung**

Die Erfindung betrifft ein Siebdruckverfahren zur Herstellung gedruckter Schaltungen mittels einer gegen Ätzmittel resistenten Paste (P), bei dem Leiterbahnenmuster auf metallkaschierte Isolierstoffplatten (1) aufgedruckt werden.

Nach dem Druckvorgang und dem Abheben des Drucksiebes (4) von der Isolierstoffplatte (1) werden mittels einer mit einem atmosphärischen Unterdruck betriebenen, die wirksame Fläche des Drucksiebes (4) überstreichenden Saugrakel (7) die im Drucksieb (4) verbliebenen Pastenrückstände (11) abgesaugt.

## Beschreibung

Die Erfindung betrifft ein Siebdruckverfahren zur Herstellung gedruckter Schaltungen nach dem Oberbegriff des Anspruchs 1.

Bei einem Bedrucken von Durchgangsbohrungen aufweisenden metallkaschierten Isolierstoffplatten verbleiben in den Bereichen der jeweiligen Bohrlöcher Pastenrückstände im Drucksieb. Da diese Pastenrückstände mit jedem Druckvorgang aufbauen, ist ein konstantes Druckbild in den Bohrlochbereichen nicht machbar.

Es ist bekannt, zur Vermeidung von Pastenrückständen Bohrungsabdeckungen im Drucksieb vorzusehen. Hierbei kann es allerdings zu einer Verringerung der minimal zulässigen Restringbandbreite der Leiterbahnen und/oder zu einer Unterätzung der Restringe kommen. Es ist auch weiterhin bekannt, nach dem Bedrucken der kaschierten Isolierstoffplatte mit einer Paste einen Zwischendruck auf saugfähigem Druckgut, z. B. Papier, durchzuführen, wobei die im Drucksieb verbliebenen Pastenrückstände vom saugfähigen Druckgut aufgenommen werden. Ein derartiges Verfahren ist jedoch zeit- und materialaufwendig.

Der Erfindung liegt die Aufgabe zugrunde, ein Siebdruckverfahren zur Herstellung gedruckter Schaltungen so zu verbessern, daß beim Bedrucken von Durchgangsbohrungen aufweisenden metallkaschierten Isolierstoffplatten mit einer gegen Ätzmittel resistenten Paste ein Zwischendruck auf saugfähigem Druckgut entfallen kann.

Diese Aufgabe wird bei einem gattungsgemäßen Verfahren durch die im kennzeichnenden Teil des Anspruchs 1 angegebenen Maßnahmen sowie mit einer Anordnung nach Anspruch 5 zur Durchführung des Verfahrens nach Anspruch 1 gelöst.

Die mit der Erfindung erzielten Vorteile bestehen insbesondere darin, daß durch das vollflächige Überdrucken der Bohrungen Unterätzungen und/oder Verringerungen der minimal zulässigen Restringbandbreiten der den Bohrungen zugeordneten Lötaugen vermieden werden. Zudem kann das Einrichten des Druckbildes an dem Bohrbild der zu bedruckenden metallkaschierten Isolierstoffplatte erfolgen, wodurch Referenzbohrungen entfallen können.

Weitere vorteilhafte Ausgestaltungen der Erfindung sind in den Unteransprüchen angegeben.

Ein Ausführungsbeispiel der Erfindung ist in der Zeichnung prinzipiell dargestellt und wird im folgenden näher erläutert.

Es zeigen:
- Figur 1: eine Druckeinrichtung zum Beginn eines Druckvorganges,
- Figur 2: einen Ausschnitt einer mit einer Bohrung versehenen Isolierstoffplatte und eines darüber befindlichen Drucksiebes nach erfolgtem Druckvorgang,
- Figur 3: die Druckeinrichtung nach dem erfolgten Druckvorgang zum Beginn eines Saugrakeleinsatzes und
- Figur 4: den Ausschnitt der mit einer Bohrung versehenen Isolierstoffplatte beim Passieren der Saugrakel.

Bei einer Anordnung zur Herstellung gedruckter Schaltungen sind in an sich bekannter Weise ein zur Aufnahme einer metallkaschierten Isolierstoffplatte 1 dienender Drucktisch 2, ein an einem Siebrahmen 3 befestigtes Drucksieb 4, eine Flutrakel 5 und eine Druckrakel 6 vorgesehen. An einem nicht dargestellten, parallel zur Oberfläche des Drucksiebes 4 bewegbaren Schlittens sind, auf das Drucksieb 4 beliebig absenkbar, die Flutrakel 5, die Druckrakel 6 sowie eine Saugrakel 7 gelagert, wobei sich die Flutrakel 5, die Druckrakel 6 und die Saugrakel 7 über die Breite des Drucksiebes 4 erstrecken. Die über eine Schlauchverbindung 8 mit einem nicht dargestellten Unterdrucksystem verbundene Saugrakel 7 ist an ihrer Unterseite mit einer sich über die Breite des Drucksiebes erstreckenden schlitzförmigen Öffnung 9 versehen, die als Saugdüse dient.

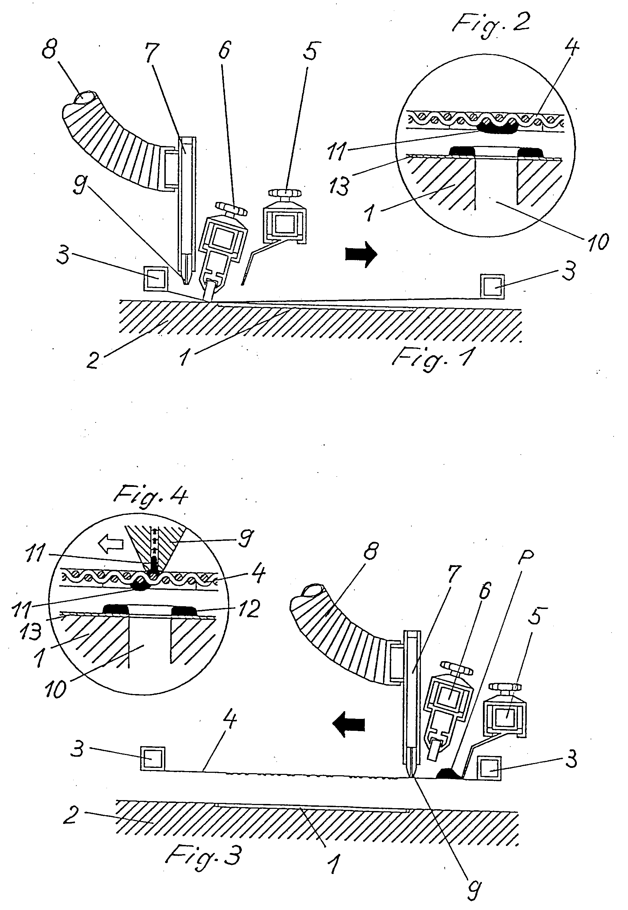

Der Druckvorgang beginnt in an sich bekannter Weise damit, daß nach einem gleichmäßigen Aufbringen einer gegen Ätzmittel resistenten Paste (P) mittels der Flutrakel 5 der Siebrahmen 3 gegen den Drucktisch 2 und die Druckrakel 6 auf das Drucksieb 4 abgesenkt werden. Im Anschluß an diesen in der Figur 1 dargestellten Zeitpunkt wird die Druckrakel 6 von links nach rechts über die wirksame Länge des Drucksiebes 4 geführt und damit die metallkaschierte Isolierstoffplatte 1 mit einem die späteren Leiterbahnen bestimmenden Druckmuster versehen. Anschließend wird der Siebrahmen 3 mit dem Drucksieb 4 zusammen mit den Rakeln 5, 6, 7 angehoben, wobei nach Fig. 2 im Drucksieb 4 an den den Bohrungen 10 der Isolierstoffplatte 1 zugeordneten Stellen Pastenrückstände 11 haften bleiben, die es zu beseitigen gilt. Hierzu wird die Druckrakel 6 vom Drucksieb 4 abgehoben und die Flutrakel 5 sowie die Saugrakel 7 auf die Oberfläche des Drucksiebes 4 abgesenkt. Ausgehend von diesem in der Fig. 3 dargestellten Zeitpunkt werden die Rakeln 5, 6, 7 von rechts nach links über die wirksame Länge des Drucksiebes 4 zurückgeführt, wobei mit der Saugrakel 7, wie in der Fig. 4 dargestellt, die Pastenrückstände 11 aus dem Drucksieb 4 abgesaugt werden. Bei diesem Vorgang wird gleichzeitig eine Pastenschicht mit der Flutrakel 5 aufgebracht. Die mit einem sauberen Druckbild 12 auf der Metallkaschierung 13 versehene Isolierstoffplatte 1 kann nun zur weiteren Bearbeitung entnommen und eine weitere Isolierstoffplatte eingelegt werden.

## Patentansprüche

1. Siebdruckverfahren zur Herstellung gedruckter Schaltungen, bei dem Leiterbahnenmuster auf Durchgangsbohrungen aufweisende, metallkaschierte Isolierstoffplatten aufgedruckt werden, indem eine gegen Ätzmittel resistente Paste mittels einer Druckrakel durch die Öffnungen eines Drucksiebes gedrückt wird,
dadurch gekennzeichnet,
daß nach dem Abheben des Drucksiebes (4) von der bedruckten Isolierstoffplatte (1) eine mit einem atmosphärischen Unterdruck betriebene Saugrakel (7) an das Drucksieb (4) angelegt und die wirksame Fläche des Drucksiebes (4) überstreichend derart über das Drucksieb (4) geführt wird, daß die vom Druckvorgang im Drucksieb (4) verbliebenen Pastenrückstände (11) abgesaugt werden.

2. Siebdruckverfahren nach Anspruch 1,
dadurch gekennzeichnet,
daß die im Leiterbahnenmuster der Isolierstoffplatte (1) vorgesehenen Bohrungen (10) beim Druckvorgang mit einer aus der gegen Ätzmittel resistenten Paste (P) gebildeten geschlossenen Schicht abgedeckt werden.

3. Siebdruckverfahren nach Anspruch 1,
dadurch gekennzeichnet,
daß beim Druckvorgang gegen Ätzmittel resistente Paste (P) mindestens bis auf die Dicke der Metallkaschierung (13) in die im Leiterbahnenmuster vorgesehenen Bohrungen (10) der Isolierstoffplatte (1) hineingedruckt wird.

4. Siebdruckverfahren nach einem der Ansprüche 1 bis 3,
dadurch gekennzeichnet,
daß das Einrichten des Druckbildes an dem bereits vorhandenen Bohrlochbild erfolgt.

5. Anordnung für ein Siebdruckverfahren nach Anspruch 1, mit einem eine metallkschierte Isolierstoffplatte (1) aufweisenden Drucktisch (2), einem darüber angeordneten, auf die Isolierstoffplatte (1) absenkbaren Drucksieb (4) und mit einer sich über die Breite des Drucksiebes (4) erstreckenden, an dessen Oberseite anlegbaren, über die Länge des Drucksiebes führbaren Druckrakel (6),
dadurch gekennzeichnet,
daß eine sich über die Breite des Drucksiebes (4) erstreckende, an dessen Oberseite anlegbare und über die Länge des Drucksiebes (4) führbare, mit einem atmosphärischen Unterdrucksystem verbundenen Saugrakel (7) vorgesehen ist, welche an ihrer Unterseite eine sich über die Breite des Drucksiebes (4) erstreckende, schlitzförmige Öffnung (9) aufweist, die als Saugdüse für im Drucksieb (4) verbliebene Pastenrückstände (11) dient.
